Europäisches Patentamt

European Patent Office

Office européen des brevets

(11) Publication number: **0 379 211**
**A2**

## (12) EUROPEAN PATENT APPLICATION

(21) Application number: **90101085.0**

(22) Date of filing: **19.01.90**

(51) Int. Cl.5: **F25D 17/02, F25D 19/04, H05K 7/20**

(30) Priority: **19.01.89 JP 11225/89**
**26.01.89 JP 17190/89**

(43) Date of publication of application:
**25.07.90 Bulletin 90/30**

(84) Designated Contracting States:
**DE FR GB NL**

(71) Applicant: **NEC CORPORATION**
**7-1, Shiba 5-chome Minato-ku**
**Tokyo 108-01(JP)**

(72) Inventor: **Matsuo, Yoichi**
**c/o NEC Corporation, 33-1, Shiba 5-chome**
**Minato-ku, Tokyo(JP)**

(74) Representative: **Vossius & Partner**
**Siebertstrasse 4 P.O. Box 86 07 67**
**D-8000 München 86(DE)**

(54) **Cooling apparatus.**

(57) A cooling apparatus (1) includes a main inlet (86) connected to a return tube (85) of a main apparatus (80) to be cooled for receiving coolant from the main apparatus. A main heat exchanger unit (10) connected to the main inlet (86) cools the heated coolant. The main heat exchanger (10) has the capacity for cooling only heat generated by the main apparatus (80). A main outlet (81) is connected to the main apparatus (80) for supplying coolant to the main apparatus. An assistant tube (7) is provided for receiving additional coolant from outside of the cooling apparatus (1), the additional coolant being stored within the cooling apparatus. An optional outlet (91) is connected to a coolant receptacle in the cooling apparatus to supply coolant to an optional apparatus (90).

Fig. 7

## COOLING APPARATUS

The present invention relates to a cooling apparatus for cooling a heated electrical system by supplying chilled coolant to the electrical system.

An electrical system such as a computer system includes at least a main apparatus. If necessary, one or more optional apparatuses are added to the system so as to comply with a required processing capability. In order to cool such a system, first and second arrangements have been proposed as a conventional cooling system.

In the first arrangement, only one cooling apparatus is used to cool the entire electrical or computer system. Such a cooling apparatus is required to have a cooling capacity sufficient to cool a maximum-structured system, i.e., a system having the maximum number of optional apparatuses. Therefore, the cooling apparatus has an excess cooling capacity when used to cool a smaller system, i.e., a system having less than the maximum number of optional apparatuses. As a result, the first arrangement has a disadvantage that the cooling apparatus is uneconomical when used to cool other than the maximum-structured system.

In the second arrangement, a plurality of individual cooling apparatuses are provided for cooling the main and optional apparatuses, respectively. The cooling capability of each of the cooling apparatuses can be smaller than that of the first arrangement. However, each of the cooling apparatuses requires a controller for controlling the operation thereof so that the cost of the whole cooling apparatus is increased.

Therefore, an object of the present invention is to provide a cooling apparatus capable of adjusting its cooling capacity to comply with the structure of an electrical system to be cooled.

Another object of the present invention is to provide a cooling apparatus having a simple structure and low cost.

A cooling apparatus according to the present invention includes: a main inlet connected to a first return tube of a main apparatus for receiving coolant heated by a main apparatus; a main heat exchanger unit connected to the main inlet for cooling the heated coolant, the main heat exchanger unit having a cooling capability to cool the heat generated by only the main apparatus; coolant receiving means connected to the main heat exchanger unit for receiving coolant cooled by the main heat exchanger unit; a main outlet connected to a first supply tube of the main apparatus for supplying the coolant from the coolant receiving means to the main apparatus; an assistant tube for receiving additional coolant from outside of the cooling apparatus and leading the additional coolant to the coolant receiving means; and an optional outlet connected to the coolant receiving means.

The invention is further described in connection with the drawings in which

Fig. 1 is a block diagram showing a first conventional cooling apparatus.

Figs. 2A and 2B show structures of a heat exchanger unit used in the cooling apparatus shown in Fig. 1.

Figs. 3A and 3B are block diagrams of a power source unit used in the cooling apparatus shown in Fig. 1.

Fig. 4 is a block diagram showing a second conventional cooling apparatus.

Figs. 5A and 5B show structures of a heat exchanger unit used in the cooling apparatus shown in Fig. 4.

Figs. 6 and 7 are block diagrams showing a first embodiment of the present invention.

Figs. 8 and 9 show heat exchanger units used in the first embodiment shown in Figs. 6 and 7.

Fig. 10 shows a control unit used in the first embodiment shown in Figs. 6 and 7.

Fig. 11 shows a block diagram of a power source unit used in the first embodiment shown in Fig. 7.

Figs. 12 and 13 are block diagram showing a second embodiment of the present invention.

Fig. 14 is a block diagram of a power source unit used in the second embodiment.

In the drawings, like elements bear the same reference numerals.

### DETAILED DESCRIPTION OF THE PREFERRED EMBODIMENTS

In order to clarify the features of the present invention, the conventional cooling apparatus will be first described with reference to the drawings.

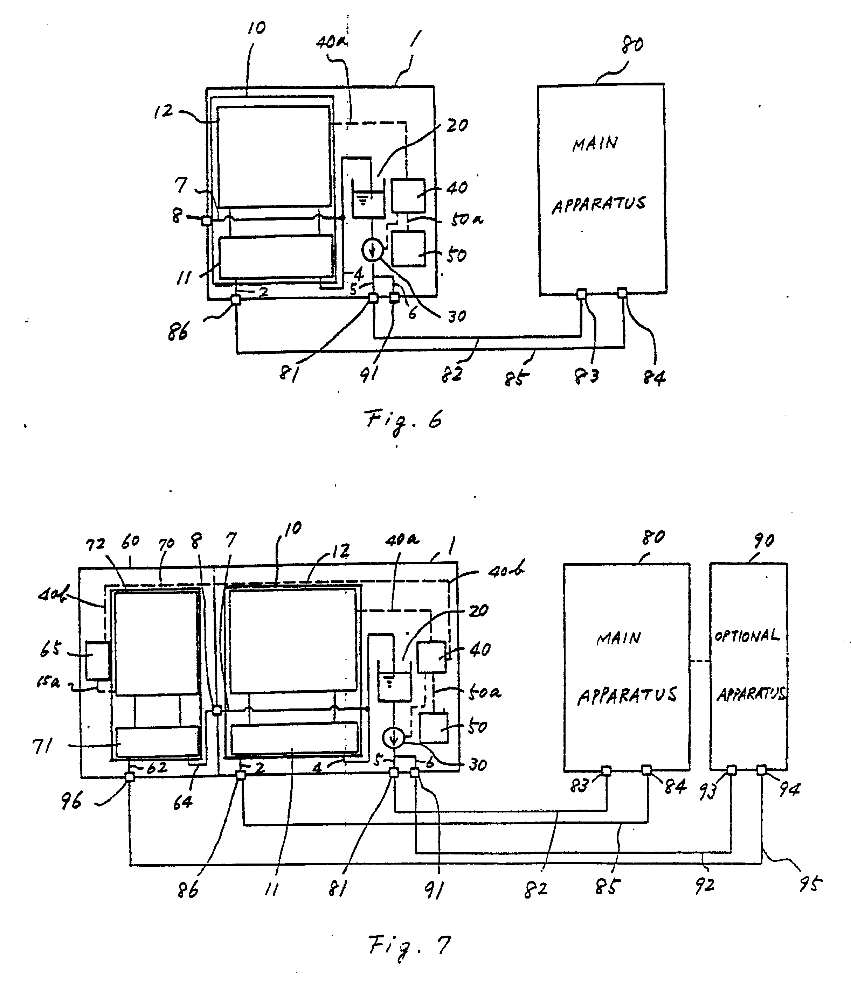

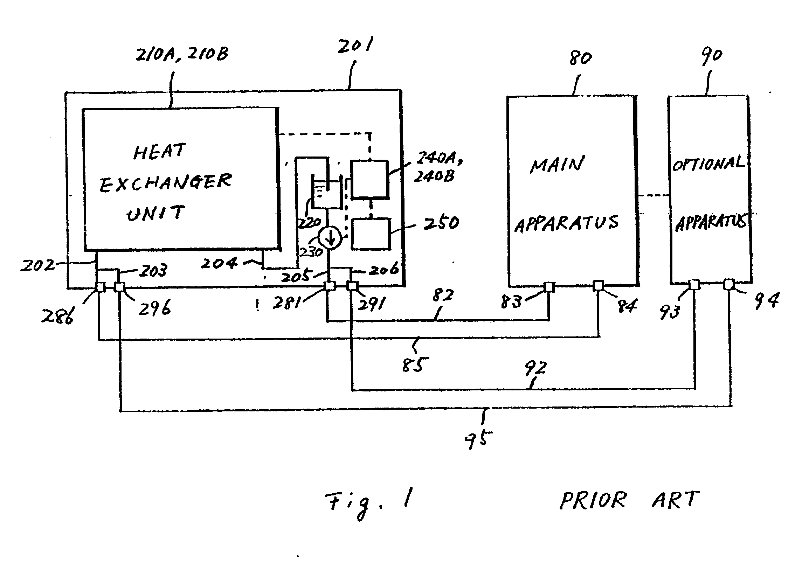

Referring to Fig. 1, a conventional cooling apparatus 201 according to a first conventional arrangement supplies a chilled water coolant to a main apparatus 80 via a first outlet 281, a first supply tube 82 and an inlet 83 of the main apparatus 80. The water coolant thus supplied is used as an exchanger medium to cool an interior of the main apparatus 80 and is thus heated. The heated water coolant returns to the cooling apparatus 201 via an outlet 84, a first return tube 85 and a first inlet 286. The cooling apparatus 201 supplies the water coolant also to an optional apparatus 90 via a second outlet 291, a second supply tube 92 and an inlet 93. The water coolant heated by the optional apparatus 90 is returned to the cooling apparatus 201 via an outlet 94, a second return tube 95 and a second inlet 296.

The cooling apparatus 201 includes a heat exchanger unit 210A or 210B for cooling the heated water coolant returning from the first and second inlets 286 and 296 via inner return tubes 202 and 203. The cooled water coolant is supplied to a tank 220 via tank tube 204 and stored therein. A pump 230 sends out the cooled water coolant from the tank 220 to the first and second outlets 281 and 291 via inner supply tubes 205 and 206.

The heat exchanger unit 210A or 210B and the pump 230 are supplied with electric power from a power source unit 240A or 240B. The operation of the power source unit 240A or 240B is controlled by a control unit 250.

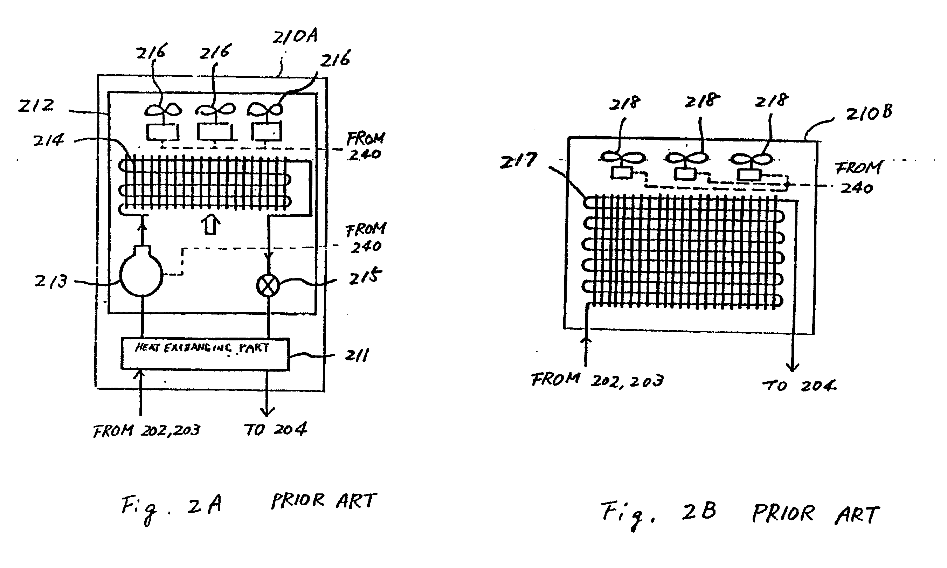

Figs. 2A and 2B show, respectively, structures of the heat exchanger units 210A and 210B. Referring to Fig. 2A, the heat exchanger unit 210A includes a heat exchanging part 211 and a freezing cycle part 212 which supplies cooled flon (i.e. fluorocarbon) gas to the heat exchanging part 211. The heat exchanging part 211 cools the water coolant by use of the cooled flon gas. The freezing cycle part 212 has a compressor 213 for compressing the flon gas used in the exchanging part 211, an air-cooled condenser 214 for radiating the heat from the flon gas and an expansion valve 215 for supplying the cooled flon gas to the exchanging part 211, as is well known in the art. Three fans 216 are provided for cooling the condenser 214.

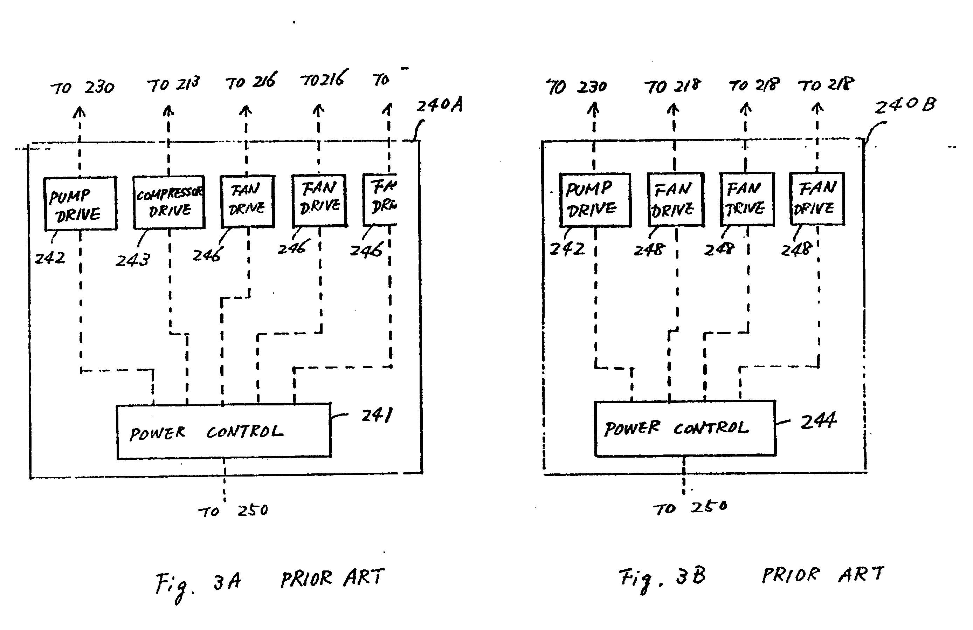

The power source unit 240A for driving the heat exchange unit 210A and the pump 230 is shown in Fig. 3A. The unit 240A includes a power control circuit 241 for controlling a pump driving circuit 242, a compressor driving circuit 243 and fan driving circuits 246 in response to command from the control unit 250. The pump driving circuit 242, compressor driving circuit 243 and fan driving circuits 246 energize the pump 230, compressor 213 and fans 216, respectively.

The heat exchanger unit 210B is shown in Fig. 2B. In this type, a heat exchanging pipe 217 of a cross-fan configuration is provided for cooling the water coolant which flows therein. Three fans 218 cool the exchanging pipe 217 by forcing cool air introduced from the outside across exchaning pipe 217.

Fig. 3B shows the power source unit 240B for the heat exchanger unit 210B. The unit 240B includes a power control circuit 244 for controlling a pump driving circuit 242 and fan driving circuits 248, similar to those of the unit 240A.

Referring back to Fig. 1, the cooling capacity of the cooling apparatus 201 is enough to cool the heat generated by a maximum-structured system which includes the main apparatus 80 and optional apparatus 90. This means that the heat exchanging capacity of the heat exchanger unit 210A or 210B and the electrical capacity of the power source 240A or 240B are required to be large enough to cool the maximum-structure system. Therefore, the cooling apparatus 201 has excess cooling capacity when used for a smaller-structure system, which includes only the main apparatus 80, for instance. In this case, the cooling apparatus 201 is uneconomical, large sized and consumes large electrical power for cooling the smaller-structured system. If the cooling capacity of a cooling apparatus is designed to be smaller to comply with the smaller-structured system, a disadvantage will occur that the enlargement of the system, i.e., adding the optional system 90 to the smaller-structured system, requires changing the cooling apparatus to have a large cooling capacity.

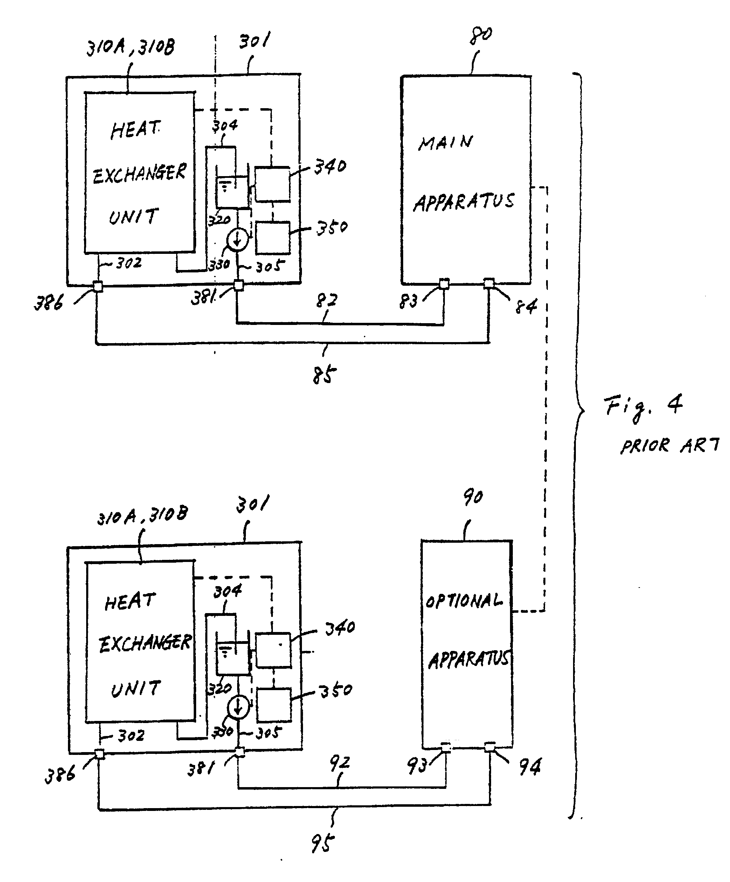

In an effort to solve the above-mentioned problems, the conventional cooling apparatus 301 according to a second conventional arrangement has been proposed as shown in Fig. 4. In this manner, a plurality of cooling apparatuses 301 having the same cooling capacity, are provided for each of the main and optional apparatuses 80 and 90.

Each cooling apparatus 301 comprises a heat exchanger unit 310A or 310B, tank 320, pump 330, power source unit 340, control unit 350, outlet 381, inlet 386 and lines 302, 304 and 305, and is similar to the cooling apparatus 201. If the heat generated by the main apparatus 80 is larger than that generated by the optional apparatus 90, the cooling capacity of the cooling apparatus 301 is designed sufficient to cool the heat generated by the main apparatus 80.

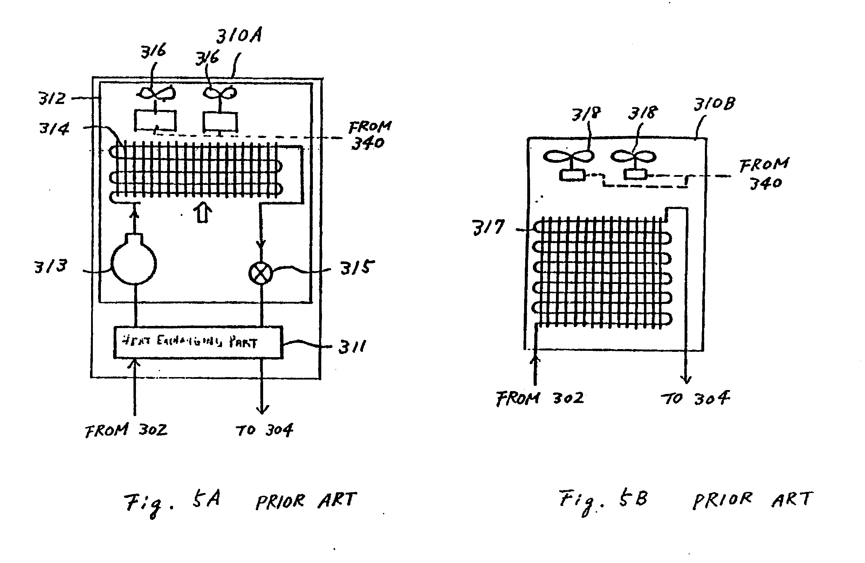

As shown in Fig. 5A, the heat exchanger unit 310A includes a heat exchanging part 311 and freezing cycle part 312 having a compressor 313, air-cooled condenser 314, expansion valve 315 and two fans 316, and is similar to the heat exchanger unit 210A.

Fig. 5B shows another type of heat exchanger unit 310B which includes a heat exchanging pipe 317 and two fans 318, and is similar to the heat exchanger unit 210B.

The cooling capability of the heat exchanger unit 310A or 310B is smaller than that of the heat exchanger unit 210A or 210B, which is represented by the number of the fans 316, 318 in Figs. 5A and 5B.

In the second conventional arrangement, each of the plurality of cooling apparatuses 301 has its own control unit 350, tank 320 and pump 330. This means that a plurality of the cooling apparatuses 301 requires a lot of hardware as a whole so that the whole cooling apparatus is expensive and large in size. Further, it is necessary to control the operation of a plurality of cooling apparatuses 301. This makes the control of the whole cooling apparatus complicated.

Embodiments of the present invention will now be described.

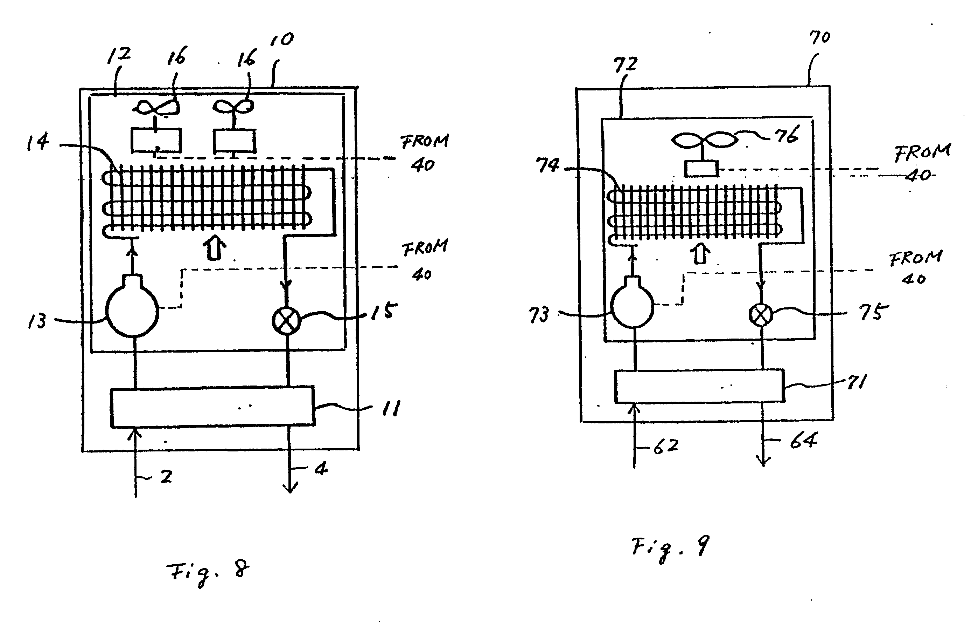

Figs. 6 and 7 show a first embodiment of the present invention in which Fig. 6 shows a cooling apparatus for cooling a small system which includes only a main apparatus 80, and Fig. 7 shows a cooling apparatus for cooling a large system which includes a main apparatus 80 and an optional apparatus 90 attached to the apparatus 80.

Referring to Fig. 6, a main cooling apparatus 1 supplies a chilled water coolant to the apparatus 80 via a main outlet 81, a first supply tube 82 and an inlet 83. The water coolant heated by the apparatus 80 returns to the main cooling apparatus 1 via an outlet 84, a first return tube 85 and a main inlet 86.

The main cooling apparatus 1 comprises a main heat exchanger unit 10 for cooling the heated water coolant returning from the main inlet 86 and an inner return tube 2. The cooled water coolant is supplied to a tank 20 through a tank tube 4 and stored therein. A pump 30 pumps out the water coolant from the tank 20 to the main outlet 81 through an inner supply tube 5. An assistant tube 7 is connected to the tank tube 4 for supplying additional cooled water coolant to the tank 20. One end of the assistant tube 7 has an inlet port 8 to be connected to an optional cooling apparatus 60 (Fig. 7). An inner supply tube 6 is connected between the pump 30 and an optional outlet 91. Since the system shown in Fig. 6 has no optional apparatus, the inlet port 8 and the optional outlet 91 are closed.

The main heat exchanger unit 10 and the pump 30 are supplied with electric power from a main power source unit 40 via power source lines 40a. The operation of the power source unit 40 is controlled by a control unit 50 through control lines 50a. (The power source lines 40a and control lines 50a are illustrated by one line in Figs. 6 and 7.)

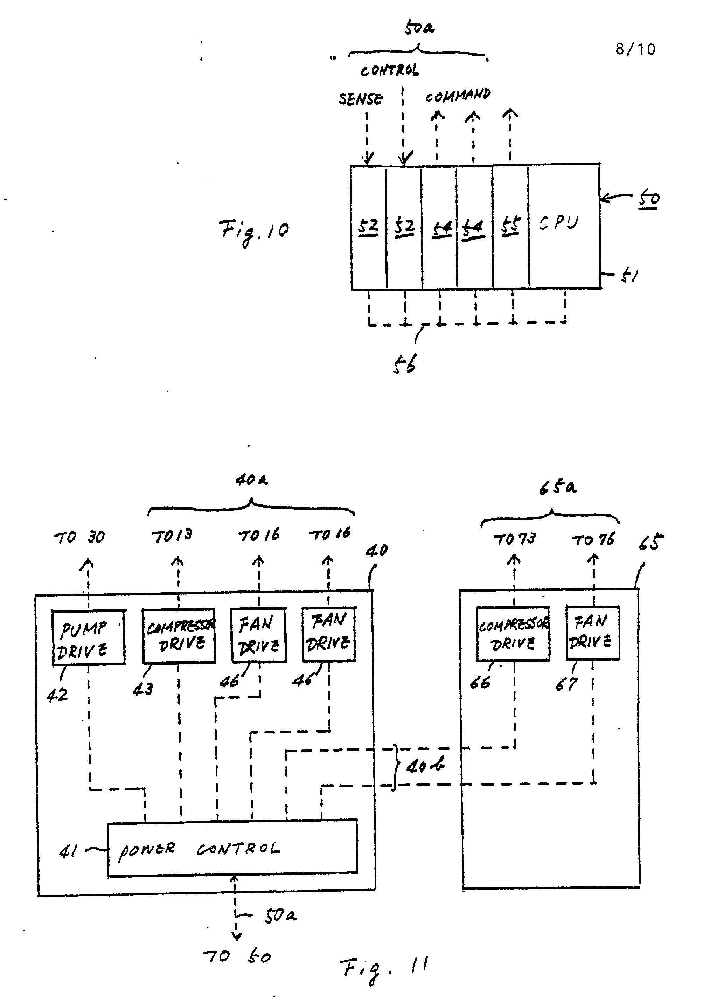

Referring also to Fig. 8, the main heat exchanger unit 10 includes a heat exchanging part 11 and a freezing cycle part 12 which supplies cooled flon gas to the heat exchanging part 11. The heat exchanging part 11 cools the water coolant by use of the cooled flon gas. The freezing cycle part 12 has a compressor 13 for compressing the flon gas used in the exchanging part 11, an air-cooled condenser 14 for radiating the heat from the flon gas and an expansion valve 15 for supplying the cooled flon gas to be exchanging part 11, as is well known in the art. Two fans 16 are provided for cooling the condenser 14.

The cooling capacity of the main heat exchanger unit 10 is such as to cool the heat generated only by the main apparatus 80. Therefore, the structure and cooling capacity of the main heat exchanger unit 10 are the same as those of the heat exchanger unit 310A shown in Fig. 5A.

Referring to Fig. 7, when the system shown in Fig. 6 is enlarged, i.e., when the optional apparatus 90 is added to the main apparatus 80, an optional cooling apparatus 60 is attached to the main cooling apparatus 1. The apparatus 60 comprises an optional heat exchanger unit 70 having a cooling capability for cooling the heat generated by the optional apparatus 90. The apparatus 60 further comprises an optional power source unit 65, which is connected to the main power source unit 40 by a line 40b, for supplying electric power to the optional heat exchanger unit 70 via power source lines 65a.

Second supply and return tubes 92 and 95 attached to the optional apparatus 90 are connected to the optional outlet 91 and an optional inlet 96, respectively.

The water coolant cooled by said exchanger unit 70 is supplied to the assistant tube 7 of the main cooling apparatus 1 through an inner supply tube 64 which is connected to the inlet port 8. The water coolant passes through the tube 7, and the tank tube 4 and is stored in the tank 20. The pump 30 sends the cooled water coolant to the outlets 81 and 91 through the inner tubes 5 and 6 so as to supply the water coolant to the main and optional apparatuses 80 and 90.

The water coolant heated by the main apparatus 80 returns to the main cooling apparatus 1 as mentioned above. The water coolant heated by the optional apparatus 90 returns to the optional cooling apparatus 60 through the second return tube 95 and an optional inlet 96. The optional heat exchanger unit 70 cools the heater water coolant returning from an inner return tube 62.

As shown in Fig. 9, the optional heat exchanger unit 70 includes a heat exchanging part 71 and a freezing cycle part 72 having a compressor 73, an air-cooled condenser 74, an expansion valve 75 and a fan 76, whose functions are similar to those of the main heat exchanger unit 10. Since the optional apparatus 90 generates less heat than the main apparatus 80, the cooling capability of the heat exchanger unit 70 is less than that of the exchanger unit 10, which is represented by the single fan 76 in Fig. 9.

The structure of the control unit 50 is schematically shown in Fig. 10. The control unit 50 includes a CPU module 51 having a ROM for storing a program, input modules 52 for inputting sense signals and control signals supplied from the power source units 40, output modules 54 for outputting command signals to the power source unit 40, and a communication module 55 for informing the states of the operation of the cooling apparatus 1.

The CPU module 51 knows the state of the unit 40 by communicating with the input modules 52 and 53 through an inner bus 56. The CPU module 51 processes the sense and control signals according to the program stored in the ROM so as to output the command signals to the power source unit 40 via the output modules 54. For the control unit 50, the programmable controller C200H manufactured and sold by Omron Tateisi Electrics Co. can be applied, for instance.

In contrast to the conventional cooling apparatus shown in Fig. 4, the cooling apparatus of this embodiment can be controlled by the single control unit 50 even if the optional apparatus 90 is attached to the main apparatus 80. Therefore, the hardware of the whole cooling apparatus can be reduced and the control of the whole cooling apparatus can be simplified.

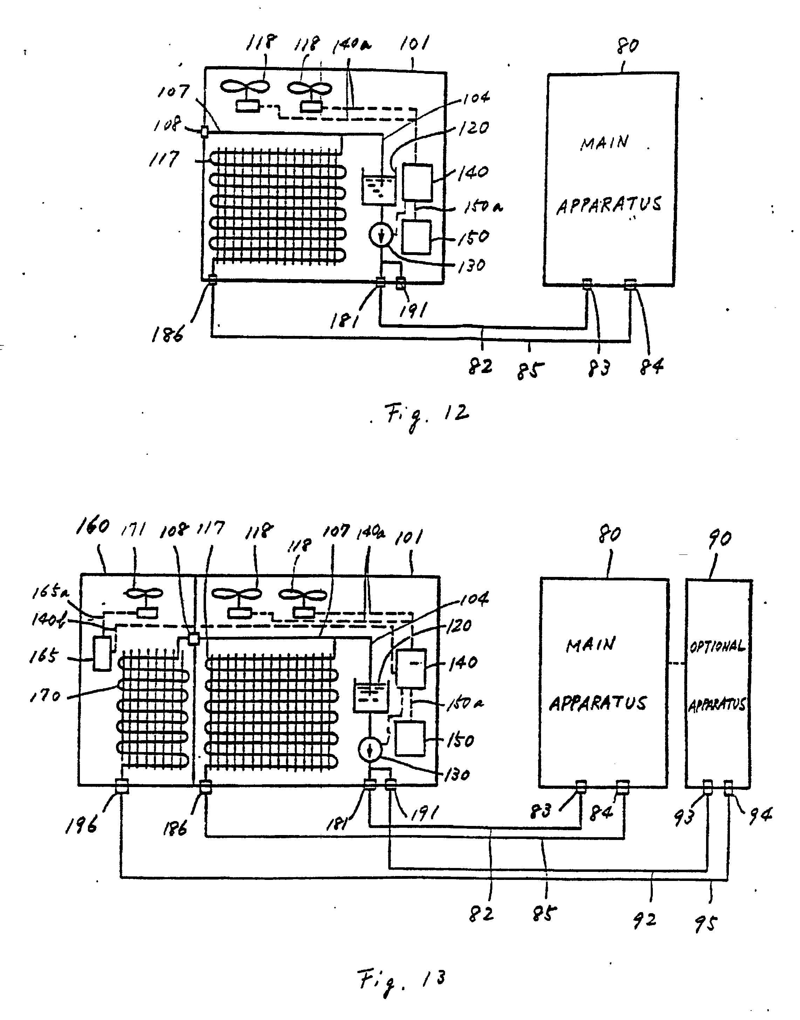

Referring to Fig. 11, the main power source unit 40 includes a power control circuit 41 for controlling the energization of a pump driving circuit 42, a compressor driving circuit 43 and two fan driving circuits 46 in response to the command signals from the control unit 50. The optional power source unit 65 includes a compressor driving circuit 66 and a fan driving circuit 67 for driving the compressor 73 and the fan 76, respectively. When the optional cooling apparatus 60 is attached to the main cooling apparatus 1, the circuits 66 and 67 are connected to the power control circuit 41 by the power source lines 40b.

The power control circuit 41 has a main breaker, noise filter, electromagnetic relays, and so on, as well known in the art, and controls electric power for all of the components of the main and optional cooling apparatuses 80 and 90. Each of the pump driving circuit 42, compressor driving circuits 43 and 66 and fan driving circuits 46 and 67 includes electromagnetic relays, a safety circuit for preventing a motor from overheating, an so on. Each of the compressor driving circuits 43 and 66 has a current capacity for driving the compressors 13 and 73 to cool the heat generated by the main and optional apparatus 80 and 90, respectively. The pump driving circuits 42 has a current capacity for driving the pump 30 enough to pump out the water coolant both to the apparatuses 80 and 90.

In contrast to the conventional power source unit 240A shown in Fig. 3A, the main power source unit 40 has fewer fan driving circuits 46 when the cooling apparatus is required to cool only the main apparatus 80. Additionally, the compressor driving circuit 43 has a lower current capacity than the conventional compressor driving circuit 243. Therefore, the size and current capacity of the main cooling apparatus 1 can be reduced in comparison with those of the conventional cooling apparatus 201.

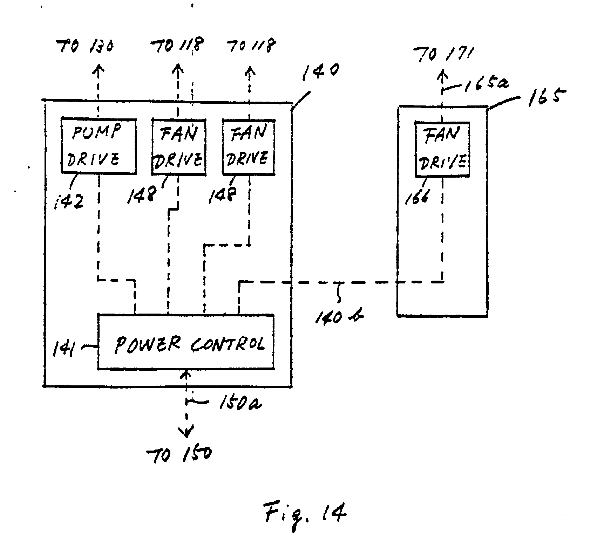

A second embodiment of the present invention will now be described with reference to Figs. 12 and 13. Fig. 12 shows a cooling apparatus for cooling a small system which includes only a main apparatus 80, and Fig. 13 shows a cooling apparatus for cooling a large system which includes a main and optional apparatuses 80 and 90. Elements similar to those of the first embodiment (Figs. 6 and 7) bear similar reference numerals in Figs. 12 and 13. The difference between the first and second embodiments is the structure of the heat exchanger unit.

Referring to Fig. 12, a main outlet 181 and main inlet 186 of a main cooling apparatus 101 are connected to the first supply tube 82 and first return tube 85 of the main apparatus 80, respectively. The main cooling apparatus 101 comprises a tank 120, a pump 130, a power source unit 140 and a control unit 150, whose functions are similar to those of the first embodiment.

The main outlet 186 is connected to a heat exchanging pipe 117 of a cross-fin configuration which cools the heated water coolant returning from the main apparatus 80. Two fans 118 are provided for cooling the outside of the exchanging pipe 117. The water coolant cooled by the pipe 117 is supplied to the tank 120 via a tank tube 104 and then to the apparatus 80 with the aid of the pump 130.

An assistant tube 107 is connected to the tank tube 104. One end of the tube 107 has an inlet port 108 for connecting an optional cooling apparatus 160 (Fig. 13) to the assistant tube 107. The inlet port 108 and an optional outlet 191 are closed in the Fig. 12 configuration.

The cooling capability of the heat exchanging pipe 117 and the fans 118 and the current capacity of the power source unit 140 are designed to cool the heat generated by only the main apparatus 80.

When the optional apparatus 90 is attached to the main apparatus 80, the optional cooling apparatus 160 is attached to the main cooling apparatus 101 by connecting an outlet of a heat exchanging pipe 170 to the inlet port 108 as shown in Fig. 13. The optional outlet 191 is connected to the second supply tube 92 while an optional inlet 196 positioned in an inlet of the pipe 170 is connected to the second return tube 95. The optional cooling apparatus 160 further includes an optional power source unit 165 which drives a fan 171 through power source line 165a for cooling the pipe 170. The optional power source unit 165 are connected to the main power source unit 140 by a control line 140b.

The water coolant heated by the optional apparatus 90 returns to the optional cooling apparatus 160 through the return tube 95 and the inlet 196. The water coolant is then cooled by the heat exchanging pipe 170 and the fan 171 and sent out to the assistant tube 107 so as to be merged with the water coolant cooled by the heat exchanging pipe 117 in the tank tube 104 and the tank 120. Next, the water coolant stored in the tank 120 is supplied to the main apparatus 80 through the outlet 181 and the optional apparatus 90 through the outlet 191.

Referring to fig. 14, the main power source unit 140 includes a power control circuit 141 for controlling the energization of a pump driving circuit 142 and two fan driving circuits 148 in response to the command signals from the control unit 150. The optional power source unit 165 includes a fan driving circuit 166 which is connected to the power control circuit 141 via the power source line 140b. The operations of the power source units 140 and 165 are similar to those of the power source units 40 and 65 except that the former do not include the compressor driving unit.

As to the control unit 150, the same structure as the first embodiment shown in Fig. 10 can be utilized.

The cooling apparatus according to the second embodiment has the same advantages as the first embodiment.

As described above, the present invention enables the cooling capacity of the cooling apparatus to be proper to the heat generated by the system to be cooled. When the system is enlarged, the cooling apparatus can also be enlarged by attaching the optional cooling apparatus which has a relatively small number of components. Therefore, simple and economical cooling apparatus can be obtained.07052

## Claims

1. A cooling apparatus for cooling a heat generating system including at least a main apparatus, said main apparatus having a first supply tube for being supplied with cool coolant cooled by said cooling apparatus and a first return tube for returning coolant heated by said main apparatus, said cooling apparatus comprising a main cooling apparatus, said main cooling apparatus comprising:
a main inlet connected to said first return tube for receiving said heated coolant;
a main heat exchanger unit connected to said main inlet for cooling said heated coolant, said main heat exchanger unit having a cooling capacity to cool the heat generated by only said main apparatus;
coolant receiving means connected to said main heat exchanger unit for receiving said cool coolant cooled by said main heat exchanger unit;
a main outlet connected to said first supply tube for supplying said cool coolant from said coolant receiving means to said main apparatus;
an assistant tube for receiving additional cool coolant from outside of said cooling apparatus and supplying said additional cool coolant to said coolant receiving means; and
an optional outlet connected to said coolant receiving means.

2. A cooling apparatus as claimed in Claim 1, wherein said main heat exchanger unit includes a heat exchanging part and a freezing cycle part, said freezing cycle part for supplying cooled flon gas to said heat exchanging part so as to cool said heated coolant.

3. A cooling apparatus as claimed in Claim 2, wherein said freezing cycle part includes a compressor for compressing said flon gas used in said heat exchanging part, an air-cooled condenser for radiating heat from said flon gas, an expansion valve for supplying said flon gas cooled by said air-cooled condenser to said heat exchanging part and a fan for cooling said air-cooled condenser.

4. A cooling apparatus as claimed in Claim 3, further comprising a main power source unit including a compressor driving circuit for driving said compressor, a fan driving circuit for driving said fan and a power control circuit for controlling energization of said compressor driving circuit and said fan driving circuit.

5. A cooling apparatus as claimed in Claims 1 to 4, wherein said main heat exchanger unit includes a heat exchanging pipe for cooling said heated coolant flowing in said heat exchanging pipe and a fan for supplying air to an outer surface of said heat exchanging pipe.

6. A cooling apparatus as claimed in Claim 5, further comprising a main power source unit including a fan driving circuit for driving said fan and a power control circuit for controlling energization of said fan driving circuit.

7. A cooling apparatus as claimed in Claims 1 to 6, further comprising an optional cooling apparatus attached to said main cooling apparatus when said heat generating system further includes an optional apparatus having a second supply tube connected to said optional outlet for being supplied with cool coolant and a second return tube for returning coolant heated by said optional apparatus, said optional cooling apparatus including:
an optional inlet connected to said second return tube for receiving said coolant heated by said optional apparatus;
an optional heat exchanger unit connected to said optional inlet for cooling said heated coolant received from said optional inlet, so as to produce said additional cool coolant, said optional heat exchanger unit having a cooling capacity to cool the heat generated by only said optional apparatus; and

an inner supply tube connected between said optional heat exchanger unit and said assistant tube for supplying said additional cool coolant to said coolant receiving means of said main cooling apparatus.

8. A cooling apparatus as claimed in Claim 7, wherein said main heat exchanger unit includes a first heat exchanging part and a first freezing cycle part and said optional heat exchanger unit includes a second heat exchanging part and a second freezing cycle part, said first and second freezing cycle parts for supplying cooled flon gas to said first and second heat exchaning parts, respectively, so as to cool said heated coolant.

9. A cooling apparatus as claimed in Claim 8, wherein said first freezing cycle part includes a first compressor for compressing first flon gas used in said first heat exchanging part, a first air-cooled condenser for radiating heat from said first flon gas, a first expansion valve for supplying said first flon gas cooled by said first air-cooled condenser to said first heat exchanging part and a first fan for cooling said first air-cooled condenser, and said second freezing cycle part having a second compressor for compressing second flon gas used in said second heat exchanging part, a second air-cooled condenser for radiating heat from said second flon gas, a second expansion valve for supplying said second flon gas cooled by said second air-cooled condenser to said second heat exchanging part and a second fan for cooling said second air-cooled condenser.

10. A cooling apparatus as claimed in Claim 9, wherein said main cooling apparatus further comprises a main power source unit including a first compressor driving circuit for driving said first compressor, a first fan driving circuit for driving said first fan and a power control circuit for controlling energization of said first compressor driving circuit and said first fan driving circuit, and said optional cooling apparatus further comprises an optional power source unit including a second compressor driving circuit for driving said second compressor and a second fan driving circuit for driving said second fan, said second compressor driving circuit and said second fan driving circuit being controlled by said power control circuit.

11. A cooling apparatus as claimed in Claim 7, wherein said main heat exchanger unit includes a first heat exchanging pipe for cooling said heated coolant flowing in said first heat exchanging pipe and a first fan for supplying air to an outer surface of said first heat exchanging pipe, and said optional heat exchange unit including a second heat exchanging pipe for cooling said heated coolant flowing in said second heat exchanging pipe and a second fan for supplying air to an outer surface of said second heat exchanging pipe.

12. A cooling apparatus as claimed in Claim 11, wherein said main cooling apparatus further comprises a main power source unit including a first fan driving circuit for driving said first fan and a power control circuit for controlling energization of said first fan driving circuit, and said optional cooling apparatus further comprises an optional power source unit including a second fan driving circuit for driving said second fan, said second fan driving circuit being controlled by said power control circuit.

Fig. 6

Fig. 7

Fig. 1     PRIOR ART

216  216  210A  216

212

214

FROM 240

FROM 240

213

215

HEAT EXCHANGING PART  211

FROM 202,203  TO 204

Fig. 2A  PRIOR ART

218  218  218  210B

217

FROM 240

FROM 202,203  TO 204

Fig. 2B  PRIOR ART

EP 0 379 211 A2

**Fig. 3B PRIOR ART**

240B

TO 218

TO 218  TO 218

TO 218

TO 218

TO 230

FAN DRIVE — 248

FAN DRIVE — 248

FAN DRIVE — 248

PUMP DRIVE — 242

POWER CONTROL — 244

TO 250

**Fig. 3A PRIOR ART**

240A

TO

TO 216

TO 216

TO 216

TO 213

TO 230

FAN DRIVE — 246

FAN DRIVE — 246

FAN DRIVE — 246

COMPRESSOR DRIVE — 243

PUMP DRIVE — 242

POWER CONTROL — 241

TO 250

Fig. 4
PRIOR ART

Fig. 5B   PRIOR ART

Fig. 5A   PRIOR ART

Fig. 8

Fig. 9

EP 0 379 211 A2

Fig.10

Fig. 11

Fig. 12

Fig. 13

TO 130    TO 118    TO 118          140        TO 171

POWER CONTROL

Fig. 14